# FASCICULE DE BREVET EUROPEEN

(11) **EP 1 090 304 B1**
(45) Date de publication et mention de la délivrance du brevet: **13.10.2004**
(21) Numéro de dépôt: 99926539.0
(22) Date de dépôt: 24.06.1999
(51) Int. Cl.: G01R 31/327

(54) **PROCEDE DE SURVEILLANCE D'ACTIONNEURS ELECTROMECANIQUES, PNEUMATIQUES OU HYDRAULIQUES, ET DISPOSITIFS POUR SA MISE EN OEUVRE**
ÜBERWACHUNGSVERFAHREN FÜR ELEKTROMAGNETISCHE, PNEUMATISCHE ODER HYDRAULISCHE AKTUATOREN UND VORRICHTUNGEN ZU SEINER DURCHFÜHRUNG
METHOD FOR MONITORING ELECTROMECHANICAL, PNEUMATIC OR HYDRAULIC ACTUATORS, AND IMPLEMENTING DEVICE

(30) Priorité: 26.06.1998 FR 9808359
(43) Date de publication de la demande: 11.04.2001
(73) Titulaire: La Poste (Exploitant Public), 92777 Boulogne Cedex (FR)
(72) Inventeur: THIERIOT, Didier, F-44000 Nantes (FR); DARCHIS, Pierre, F-44300 Nantes (FR)
(74) Mandataire: Bentz, Jean-Paul
(86) Numéro de dépôt international: PCT/FR1999/001518
(87) Numéro de publication internationale: WO 2000/000838

(56) Documents cités:
- EP-A- 0 833 166
- WO-A-97/20224
- FR-A- 2 573 212
- DATABASE WPI Section EI, Week 9239 Derwent Publications Ltd., London, GB; Class V03, AN 92-322732 XP002095670 & SU 1 690 019 A (BAKULIN S I), 7 novembre 1991 (1991-11-07)

## Description

La présente invention concerne la surveillance d'une pluralité d'actionneurs électro-mécaniques, ou pneumatiques, ou hydrauliques, regroupés au sein d'un même ensemble fonctionnel.

Un tel ensemble est typiquement une machine de tri postal, qui comporte en nombre important des mêmes électro-aimants affectés à une même fonction dont il est très difficile à ce jour d'effectuer une vérification efficace et détaillée dans le cadre d'une maintenance préventive. Il en est de même pour des ensembles regroupant des mêmes actionneurs pneumatiques ou hydrauliques.

Un procédé et un dispositif pour tester une pluralité d'actionneurs électriques est connu du document W097/20224.Dans ce système, une pluralité de capteurs sont attachés à chaque actionneur, dont les mesures sont transformées en signaux avec un code d'identification. Les signaux ainsi identifiés sont reçus dans un système de traitement de données où ils sont comparés à des valeurs nominales.

Lorsqu'un signal s'écarte d'une valeur nominale, l'information est donnée que l'actionneur dont il provient est défaillant. Ce système est lourd du fait d'abord qu'une pluralité de capteurs est prévue pour chaque actionneur et que, de plus, un jeu de capteurs est nécessaire pour chaque actionneur.

L'invention résulte d'une recherche de solution plus simple et efficace à ce problème.

Elle consiste en un procédé de surveillance et de diagnostic relatif à une pluralité d'actionneurs identiques, caractérisé en ce qu'il comprend les étapes suivantes :
- alimenter à partir d'une même source d'énergie électrique, pneumatique ou hydraulique, et dans des mêmes conditions de circuit, isolément et successivement, chacun de ladite pluralité d'actionneurs identiques ;
- établir pour chaque actionneur un relevé ou courbe du flux mesuré en fonction du temps ;
- établir une superposition à partir de l'ensemble desdites courbes, la superposition obtenue définissant une trace occupée par le plus grand nombre et considérée à ce titre comme trace de normalité ;
- isoler les courbes présentant des écarts relativement à ladite trace ; et
- établir un diagnostic d'anomalie de chaque courbe isolée, sur la base du ou des écarts qu'elle présente avec ladite trace.

Ladite superposition peut être réalisée avec la totalité de chacune desdites courbes, auquel cas la période d'excitation des actionneurs devra être identique pour tous ; ou bien elle peut être réalisée avec des parties significatives de ces courbes, auquel cas la période d'excitation pourrait varier d'un actionneur à l'autre.

Selon que les actionneurs seront des composants électriques, ou pneumatiques, ou hydrauliques, le flux mesuré sera respectivement un courant, ou un débit d'air comprimé, ou un débit de liquide hydraulique.

En pratique, il est fatal que les courants nominaux ou flux nominaux (courant ou flux relevé lors de l'état permanent sous alimentation) des différents actionneurs varient quelque peu à l'intérieur d'une plage de tolérance. Avant l'étape de superposition, il sera donc avantageux d'appliquer une transformation homothétique de chaque courbe pour ramener la valeur du courant ou flux nominal détectée à une valeur moyenne choisie. Bien entendu, avant cette opération, un premier examen pourra avoir été effectué pour repérer et analyser les défauts de courant nominal (valeur détectée en dehors de la plage précitée).

L'invention concerne également des dispositifs de mise en oeuvre du procédé défini ci-dessus, dispositifs qui peuvent être intégrés dans les ensembles ou machines comportant les éléments à surveiller, ou bien comprendre des outils de diagnostic indépendants.

Ces caractéristiques et avantages de l'invention, ainsi que d'autres, apparaîtront plus clairement dans la description suivante, faite en relation avec les dessins joints dans lesquels :
la Fig. 1 est une vue schématique d'un ensemble d'actionneurs reliés à une source d'alimentation d'une manière permettant la mise en oeuvre de l'invention ;
la Fig. 2 est un diagramme représentatif de l'intensité du courant en fonction du temps dans les actionneurs de la Fig. 1, lors de cycles de contrôle successifs de chacun d'entre eux ;
la Fig. 3 est un diagramme sur lequel apparaît, à échelle plus grande, une courbe de la Fig. 2 correspondant au cycle de l'un quelconque des actionneurs ;
la Fig. 4 est un diagramme, à même échelle que celui de la Fig. 2, représentant une superposition à partir des courbes de la Fig. 2 correspondant à chacun des actionneurs ;
et la Fig. 5 est un diagramme semblable à celui de la Fig. 4, représentant ladite superposition après traitement.

Bien que dans son principe, l'invention soit applicable à tous types d'actionneurs électro-mécaniques, elle est représentée dans les dessins et va être décrite dans la suite relativement à des électro-aimants.

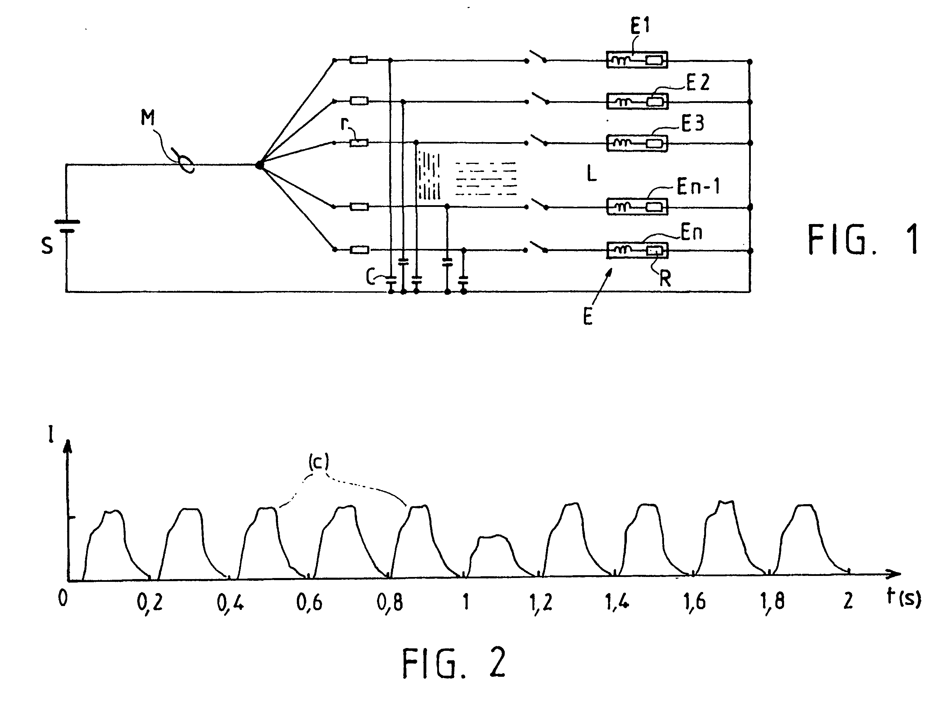

Considérant d'abord la Fig. 1, elle représente schématiquement un circuit comprenant une pluralité d'électro-aimants identiques E, plus précisément E1, E2, E3, ..., En-1, En, symbolisés par leur résistance R et leur inductance L, et connectés en parallèle à une source d'alimentation en courant continu commune S d'une manière telle qu'ils puissent être alimentés sélectivement un par un dans des conditions identiques. A la Fig. 1, le circuit comprend également, pour chaque actionneur, des moyens de protection et de suralimentation de démarrage, s'agissant d'une résistance r et d'un condensateur C, ce montage pouvant prendre place, par exemple, dans des machines de tri postal de type carrousel au sein desquelles un grand nombre d'actionneurs identiques sont affectés à une même tâche telle que la commande en ouverture/fermeture de volets obturateurs de casiers. D'autre part, le repère M désigne un capteur pour mesurer le courant en sortie de la source d'alimentation S, celui-ci pouvant être selon les cas du type basé sur le principe de l'effet Hall, ou bien un shunt calibré disposé en série, etc.

Pour un tel ensemble d'actionneurs E, y compris les composants qui leur sont individuellement associés, ici une résistance r et un condensateur C, le procédé de maintenance préventive selon l'invention pour individuellement surveiller leur état et diagnostiquer leurs défauts consiste d'abord à faire fonctionner chacun leur tour, en les alimentant individuellement pendant une même période à partir de la source S, à mesurer continûment le courant pour chaque cycle de fonctionnement, et à enregistrer le courant mesuré en fonction du temps pour obtenir une succession de courbes (c) telles que celles que montre la Fig. 2 pour les dix premiers électro-aimants E de l'ensemble.

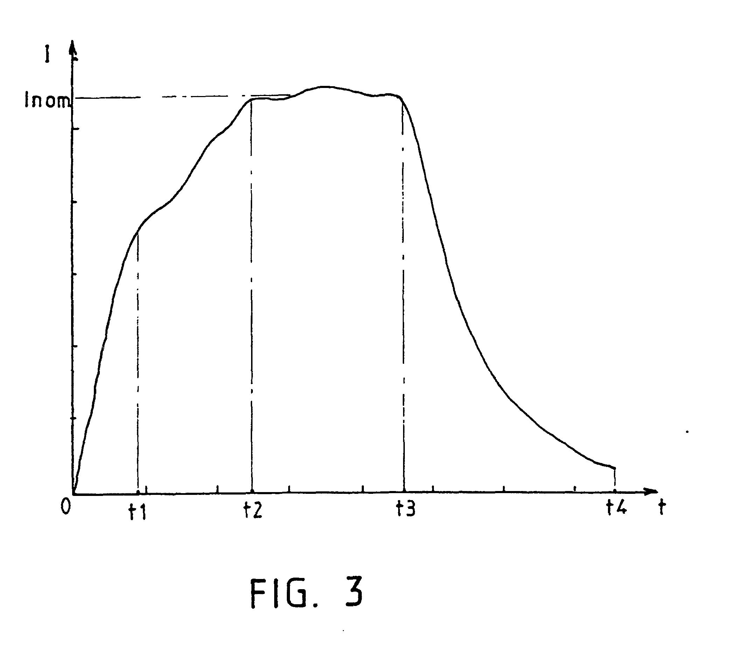

Chaque cycle de fonctionnement a par exemple une durée de 0,2 seconde, avec une durée d'alimentation de 0,10 seconde. Chaque courbe (c), telle que celle de la Fig. 3 où l'origine des temps correspond à son point de départ, comporte un front montant jusqu'à l'instant t2, dont la partie supérieure au-delà d'un léger infléchissement en t1 correspond au déplacement de l'électro-aimant entre son état de repos et son état permanent sous alimentation ; un palier entre les instants t2 et t3 correspondant à cet état permanent sous alimentation et au niveau de ce qu'il sera convenu de dénommer le courant nominal Inom de l'électro-aimant ; et un front descendant entre l'instant t3 et l'instant t4 de fin de cycle, pendant lequel le condensateur C associé se recharge.

Au terme de cette première étape du procédé, un premier contrôle peut être effectué, concernant la valeur dudit courant nominal Inom. D'après le diagramme de la Fig. 2, il est clairement visible que le sixième électro-aimant présente une grave anomalie de ce côté, du fait que son courant nominal Inom se différencie très nettement des valeurs, toutes voisines, appartenant à l'ensemble des neuf autres. Un premier diagnostic pourra être déduit de cette anomalie de courant nominal, éventuellement confirmé et/ou affiné par les étapes de contrôle ultérieures.

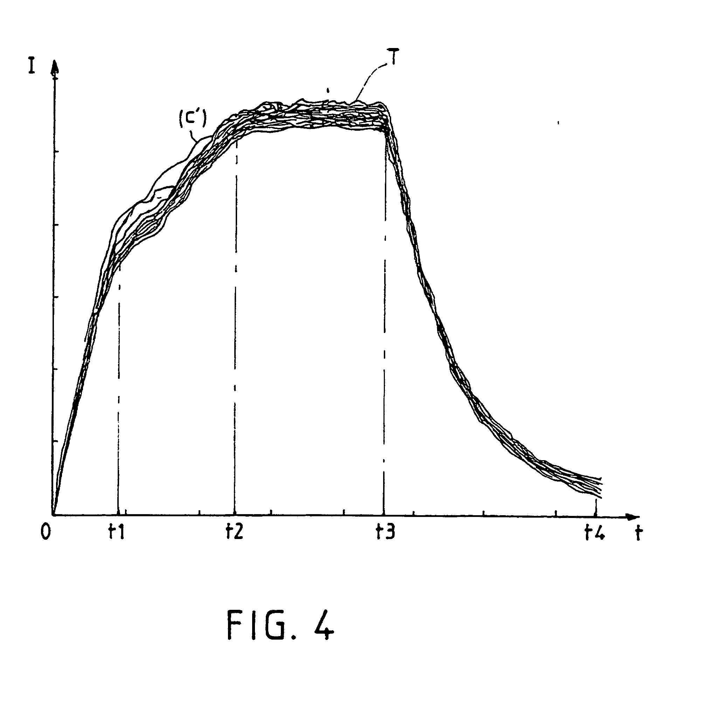

Conformément à l'invention, une seconde étape du procédé de contrôle et de surveillance des actionneurs E consiste à rassembler, superposés en un même diagramme, Fig. 4, la totalité des courbes de l'ensemble des actionneurs E. Avantageusement, celles-ci auront subi préalablement une homothétie de rapport pour ramener toutes les valeurs moyennes individuelles du courant nominal à un même niveau, afin de faire disparaître des écarts minimes résultant de tolérances des composants, notamment des résistances.

Cette superposition de courbes (c'), transformées des courbes (c), Fig. 4, fait apparaître une trace T, laquelle présente une partie médiane particulièrement dense du fait qu'elle correspond au passage de la majorité des courbes, et des lisères plus claires de part et d'autre de cette partie médiane.

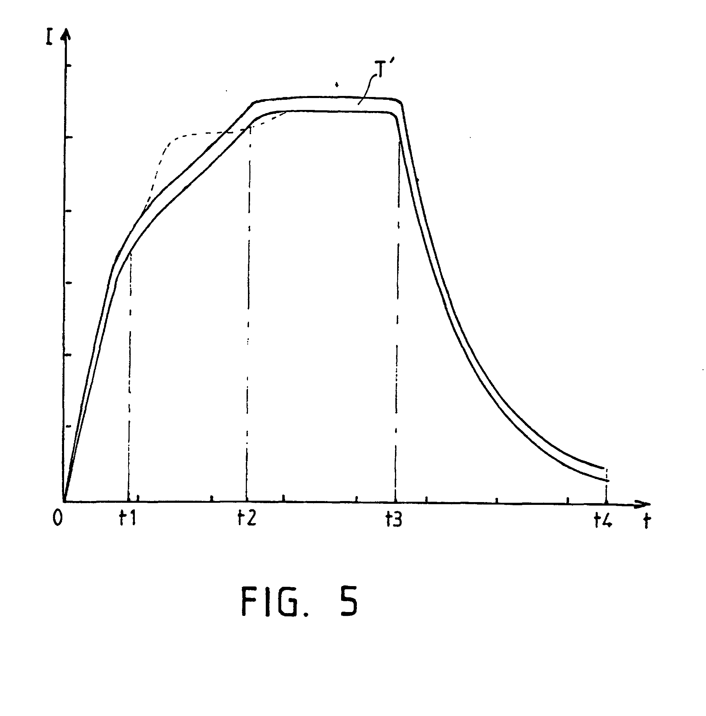

De la trace T, est déduite une trace de normalité T', Fig. 5, le critère de normalité étant qu'elle est la zone de passage des courbes (c') pour le plus grand nombre des électro-aimants E. Il conviendra de noter que la trace T' peut avoir une largeur variable, ou plus précisément, qu'en différents instants de sa période, l'écart entre sa limite inférieure et sa limite supérieure en intensité peut varier sensiblement.

De l'ensemble des courbes (c') comparées ensuite une à une avec la trace T', sont retenues celles qui s'en écartent en un ou plusieurs lieux. Pour chacune, la valeur de chaque écart (valeur moyenne et/ou valeur de crête), son sens (au-dessus ou au-dessous de la trace T'), son positionnement et son importance sur la durée (calculée par exemple par sommation des carrés), sont autant d'informations pouvant être utilisées pour faire une analyse précise en terme de défaut et d'origine de celui-ci. A titre d'exemple, une sortie au-delà de la trace T' dans la partie supérieure du front avant (t1, t2), telle que représentée en traits interrompus à la Fig. 5, sera indicatrice d'un point dur mécanique au niveau des parties mobiles de l'électro-aimant, tandis qu'un écart dans la première partie du front avant (0, t1) révèlera un problème d'inductance et/ou de résistances, un écart au niveau du palier (t2, t3) un problème d'alimentation ou de résistances, le front arrière (t3, t4) un problème de condensateur et de résistance r. Le cumul de plusieurs écarts pourra en outre être révélateur d'un défaut précis : par exemple, un écart au niveau de la première partie du front avant (0, t1) avec un écart au niveau du front arrière (t3, t4) permettrait d'affirmer avec une forte probabilité que le défaut provient d'une anomalie de la résistance r.

De ce qui précède, on peut remarquer que les parties significatives des courbes (c) sont principalement leur front montant, leur front descendant, et que les moins le palier sur sa durée. Par conséquent, on peut prévoir d'établir une trace T' et des superpositions avec les parties les plus significatives des courbes (c), ce qui permet de s'affranchir de la contrainte d'une même durée d'excitation pour l'ensemble des actionneurs.

Un dispositif pour mettre en oeuvre le procédé de maintenance préventive et de diagnostic selon l'invention exposé ci-dessus, comprenant donc pour l'essentiel des moyens pour commander la séquence de mise en fonctionnement tour à tour des actionneurs, un unique capteur de courant, des moyens d'enregistrement des données et des moyen de traitement aboutissant à l'obtention des résultats, peut être totalement intégré dans une machine, ou bien comprendre un outil de test séparé, auquel cas celui-ci peut être utilisé pour de multiples ensembles différents d'actionneurs, et des ensembles d'actionneurs différents.

Dans ce second cas, l'outil de test comprend alors un capteur de courant, avantageusement d'un type basé sur le principe de l'effet Hall, une unité de commande connectable à celle de la machine à inspecter, et des moyens de saisie et de stockage de données. Le traitement des données pour obtention des résultats est de préférence effectué par une unité de traitement séparée.

Naturellement, bien que l'invention ait été décrite en rapport avec des électro-aimants, elle peut s'appliquer de même, ou à des différences d'adaptation près totalement à la portée des techniciens du domaine, à d'autres catégories d'actionneurs électro-mécaniques, notamment des moteurs, ainsi qu'à des actionneurs pneumatiques ou hydrauliques.

L'invention est très appréciable en raison de la simplicité, et donc du faible coût des moyens qu'elle nécessite pour sa mise en oeuvre, et en raison également de la grande fiabilité que procure son principe d'étalonnage automatique. A noter de plus l'avantage d'un capteur de courant ou de flux unique, du fait de l'économie en terme de coût d'une part, et du fait également que cela dispense de l'étalonnage délicat et difficile qui est nécessaire s'ils sont plusieurs.

## Revendications

1. Procédé de surveillance et de diagnostic relatif à une pluralité d'actionneurs identiques (E), comprenant les étapes suivantes :
- alimenter à partir d'une même source d'énergie électrique, pneumatique ou hydraulique (S), et dans des mêmes conditions de circuit, isolément et successivement, chacun de ladite pluralité d'actionneurs identiques (E) ;
- mesurer en sortie de l'alimentation (S), le flux d'agent énergétique pendant le cycle d'excitation de chaque actionneur (E) ;
- établir pour chaque actionneur un relevé ou courbe (c) du flux mesuré en fonction du temps ;
- établir une superposition à partir de l'ensemble desdites courbes (c), la superposition (T) obtenue définissant une trace (T') occupée par le plus grand nombre et considérée à ce titre comme trace de normalité ;
- isoler les courbes présentant des écarts relativement à ladite trace (T') ; et
- établir un diagnostic d'anomalie de chaque courbe isolée, sur la base du ou des écarts qu'elle présente avec ladite trace (T').

2. Procédé selon la revendication 1, **caractérisé en ce que** la période d'excitation desdits actionneurs (E) est identique pour l'ensemble de ceux-ci.

3. Procédé selon la revendication 1, **caractérisé en ce que** ladite période d'excitation desdits actionneurs (E) est variable d'un actionneur à l'autre, ladite superposition étant établie à partir de portions significatives desdites courbes (c).

4. Procédé selon l'une des revendications 1 à 3, **caractérisé en ce qu'**avant l'étape de superposition, il est appliqué une transformation homothétique de chaque courbe (c) pour ramener la valeur du courant ou flux nominal détectée (Inom) à une valeur moyenne choisie, ladite superposition (T) étant réalisée avec les courbes (c') résultant de ladite transformation des courbes (c).

5. Procédé selon l'une des revendications 1 à 4, **caractérisé en ce que** préalablement à l'opération de superposition, il est effectué un premier contrôle par comparaison des courbes (c) pour repérer celles qui se différencient de la majorité d'entre elles au niveau de la valeur du courant ou flux nominal (Inom).

6. Procédé selon l'une des revendications 1 à 5, **caractérisé en ce qu'**il est appliqué à des électro-aimants.

7. Procédé selon l'une des revendications 1 à 6, **caractérisé en ce qu'**il est appliqué à des moteurs.

8. Procédé selon l'une des revendications 1 à 6, **caractérisé en ce qu'**il est appliqué à des actionneurs pneumatiques.

9. Procédé selon l'une des revendications 1 à 6, **caractérisé en ce qu'**il est appliqué à des actionneurs hydrauliques.

## Claims

1. Monitoring and diagnostic method relating to a plurality of identical actuators (E), comprising the following steps:
- supplying each of the said plurality of identical actuators (E) from one and the same electrical, pneumatic or hydraulic energy source (S), under the same circuit and insulation conditions and successively;
- measuring at the output of the supply (S), the energy agent flux during the excitation cycle of each actuator (E);
- producing for each actuator a chart or curve (c) of the flux measured as a function of time;
- producing a superposition from the set of the said curves (c), the superposition (T) obtained defining a trace (T') occupied by the largest number and considered in this respect as normality trace;
- isolating the curves exhibiting deviations relative to the said trace (T'); and
- producing an anomaly diagnostic for each curve isolated, on the basis of the deviation or deviations that it exhibits with the said trace (T').

2. Method according to Claim 1, **characterized in that** the excitation period of the said actuators (E) is identical for the whole set of them.

3. Method according to Claim 1, **characterized in that** the said excitation period of the said actuators (E) is variable from one actuator to another, the said superposition being produced from significant portions of the said curves (c).

4. Method according to one of Claims 1 to 3, **characterized in that** before the superposition step, a homothetic transformation of each curve (c) is applied so as to bring the value of the nominal current or flux detected (Inom) to a chosen mean value, the said superposition (T) being effected with the curves (c') resulting from the said transformation of the curves (c).

5. Method according to one of Claims 1 to 4, **characterized in that** prior to the superposition operation, a first check is performed by comparing the curves (c) so as to tag those which differ from the majority of them at the level of the value of the nominal current or flux (Inom).

6. Method according to one of Claims 1 to 5, **characterized in that** it is applied to electromagnets.

7. Method according to one of Claims 1 to 6, **characterized in that** it is applied to motors.

8. Method according to one of Claims 1 to 6, **characterized in that** it is applied to pneumatic actuators.

9. Method according to one of Claims 1 to 6, **characterized in that** it is applied to hydraulic actuators.

## Patentansprüche

1. Überwachungs- und Diagnoseverfahren für eine Vielzahl identischer Aktuatoren (E), das die folgenden Schritte umfaßt:
- Versorgen jedes einzelnen der Vielzahl identischer Aktuatoren (E) nacheinander aus derselben elektrischen, pneumatischen oder hydraulischen Energiequelle (S) und unter den gleichen Schaltungsbedingungen;
- Messen des Energieflusses am Ausgang der Versorgungsquelle (S) während eines Zyklus, in dem jeder Aktuator (E) aktiviert ist;
- Erstellen einer Aufstellung oder Kurve (c) des gemessenen Flusses in Abhängigkeit von der Zeit für jeden Aktuator;
- Erstellen einer Superposition ausgehend von der Gesamtheit der Kurven (c), wobei sich die Superposition (T) ergibt, indem ein Verlauf (T') definiert wird, der sich aus den größten Zahlen zusammensetzt und diesbezüglich als Normierungsverlauf betrachtet wird;
- Isolieren der Kurven, die Abweichungen von dem Verlauf (T') aufweisen; und
- Erstellen einer Anomaliediagnose jeder einzelnen Kurve auf der Basis dieser Abweichung oder Abweichungen, die sich mit diesem Verlauf (T') ergibt bzw. ergeben.

2. Verfahren nach Anspruch 1, **dadurch gekennzeichnet, daß** die Aktivierungsperiode für alle Aktuatoren (E) identisch ist.

3. Verfahren nach Anspruch 1, **dadurch gekennzeichnet, daß** sich die Aktivierungsperioden der Aktuatoren voneinander unterscheiden, wobei die Superposition ausgehend von signifikanten Abschnitten der Kurven (c) erstellt wird.

4. Verfahren nach einem der Ansprüche 1 bis 3, **dadurch gekennzeichnet, daß** vor dem Schritt des Erstellens einer Superposition eine homothetische Transformation jeder Kurve (c) ausgeführt wird, um den nominalen ermittelten Strom- oder Flußwert (Inom) auf einen gewählten Mittelwert zurückzuführen, wobei die Superposition (T) mit Kurven (c') ausgeführt wird, die sich aus der Transformation der Kurven (c) ergeben.

5. Verfahren nach einem der Ansprüche 1 bis 4, **dadurch gekennzeichnet, daß** vor dem Erstellen der Superposition eine erste Kontrolle durch Vergleichen der Kurven (c) ausgeführt wird, um diejenigen zu finden, die sich hinsichtlich der Höhe des nominalen Strom- oder Flußwerts (Inom) von der Mehrzahl unterscheiden.

6. Verfahren nach einem der Ansprüche 1 bis 5, **dadurch gekennzeichnet, daß** es auf Elektromagneten angewandt wird.

7. Verfahren nach einem der Ansprüche 1 bis 6, **dadurch gekennzeichnet, daß** es auf Motoren angewandt wird.

8. Verfahren nach einem der Ansprüche 1 bis 6, **dadurch gekennzeichnet, daß** es auf pneumatische Aktuatoren angewandt wird.

9. Verfahren nach einem der Ansprüche 1 bis 6, **dadurch gekennzeichnet, daß** es auf hydraulische Aktuatoren angewandt wird.
